# EUROPEAN PATENT APPLICATION

(11) **EP 4 672 902 A2**
(43) Date of publication of application: **31.12.2025**
(21) Application number: 25185014.5
(22) Date of filing: 24.06.2025
(51) Int. Cl.: H10D 30/67, H01L 21/02, H10D 30/01, H01L 21/285, H01L 21/768, H10D 30/69, H10D 64/68

(54) **TECHNOLOGIES FOR EPITAXIAL PEROVSKITE FERROELECTRIC TRANSISTORS ON BUFFERED SILICON**

(30) Priority: 28.06.2024 US 202418759271
(71) Applicant: INTEL Corporation, Santa Clara, CA 95054 (US)
(72) Inventor: SEN GUPTA, Arnab, Hillsboro, OR 97123 (US); BURAGOHAIN, Pratyush P., Portland, OR 97212 (US); DEBASHIS, Punyashloka, San Jose, CA 95134 (US); KIM, Raseong, Lake Oswego, OR 97034 (US); METZ, Matthew V., Portland, OR 97229 (US); PARK, Suehyun, Portland, OR 97202 (US); PLOMBON, John J., Portland, OR 97219 (US); STEINHARDT, Rachel A., Beaverton, OR 97006 (US); YOUNG, Ian Alexander, Olympia, WA 98512 (US)
(74) Representative: 2SPL Patentanwälte PartG mbB

(57) **Abstract**

Technologies for epitaxial perovskite ferroelectric transistors on buffered silicon are disclosed. In an illustrative embodiment, a barrier layer of titanium nitride is deposited on a silicon substrate using domain matching epitaxy, which allows the titanium nitride to grow with relatively low stress and a low number of defects, despite a 22% misfit between the lattice constant for titanium nitride and that lattice constant for silicon. The barrier layer prevents silicon monoxide (SiO) from forming when oxides are grown as later layers. In some embodiments, some or all of the titanium nitride barrier layer may be used as a gate electrode for the transistor.

## Description

### BACKGROUND

Transistors are ubiquitous devices present in virtually all electronic devices. As the density of transistors continues to increase, the power dissipated by the transistors needs to be addressed. The power dissipated can be removed by heat sinks or cold plates. The power dissipation of a transistor can be reduced in several ways, such as reducing leakage current and reducing the threshold voltage of the transistor.

A typical transistor can maintain its state when a voltage is maintained at a gate electrode. However, a ferroelectric field-effect transistor (FEFET) can maintain its state based on a state of a ferroelectric layer in the transistor. FEFETs typically have a relatively high threshold voltage and a corresponding relatively high leakage current.

### BRIEF DESCRIPTION OF THE DRAWINGS

FIG. 1 is an isometric view of a FET with a barrier layer between a gate electrode layer and a ferroelectric layer.
FIG. 2 is a top view of the transistor of FIG. 1.
FIG. 3 is a cross-sectional side view of the transistor of FIG. 1.
FIG. 4 is an isometric view of a ribbon field-effect transistor (FET) with a ferroelectric gate dielectric.
FIG. 5 is a top view of the transistor of FIG. 4.
FIG. 6 is a cross-sectional side view of the transistor of FIG. 4.
FIG. 7 is a simplified flow diagram of at least one embodiment of a method for creating a ribbon FET transistor with a ferroelectric gate dielectric.
FIG. 8 is a cross-sectional side view at one step of manufacturing the transistor of FIG. 4.
FIG. 9 is a cross-sectional side view at one step of manufacturing the transistor of FIG. 4.
FIG. 10 is a cross-sectional side view at one step of manufacturing the transistor of FIG. 4.
FIG. 11 is a cross-sectional side view at one step of manufacturing the transistor of FIG. 4.
FIG. 12 is a top view of a wafer and dies that may be included in a microelectronic assembly, in accordance with any of the embodiments disclosed herein.
FIG. 13 is a cross-sectional side view of an integrated circuit device that may be included in a microelectronic assembly, in accordance with any of the embodiments disclosed herein.
FIGS. 14A-14D are perspective views of example planar, FinFET, gate-all-around, and stacked gate-all-around transistors.
FIG. 15 is a cross-sectional side view of an integrated circuit device assembly that may include a microelectronic assembly, in accordance with any of the embodiments disclosed herein.
FIG. 16 is a block diagram of an example electrical device that may include a microelectronic assembly, in accordance with any of the embodiments disclosed herein.

### DETAILED DESCRIPTION

In one embodiment disclosed herein, as described in more detail below, the gate dielectric of a field-effect transistor (FET) is barium titanate (BTO), a ferroelectric material. The transistor is grown on a silicon substrate. In order to prevent silicon monoxide (SiO) from forming when oxides are grown, a barrier layer of titanium nitride is grown on the silicon before other layers of the transistor are deposited. The titanium nitride can be grown on the silicon using domain matching epitaxy, which allows the titanium nitride to grow with relatively low stress and a low number of defects, despite a 22% misfit between the lattice constant for titanium nitride and that lattice constant for silicon. In some embodiments, the titanium nitride may act as a gate electrode.

As used herein, the phrase "communicatively coupled" refers to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate, and an integrated circuit component attached to a printed circuit board that send signals to or receives signals from other integrated circuit components or electronic devices attached to the printed circuit board.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact and "coupled" may indicate elements co-operate or interact, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, the central axis of a magnetic plug that is substantially coaxially aligned with a through hole may be misaligned from a central axis of the through hole by several degrees. In another example, a substrate assembly feature, such as a through width, that is described as having substantially a listed dimension can vary within a few percent of the listed dimension.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons.

Reference is now made to the drawings, which are not necessarily drawn to scale, wherein similar or same numbers may be used to designate the same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

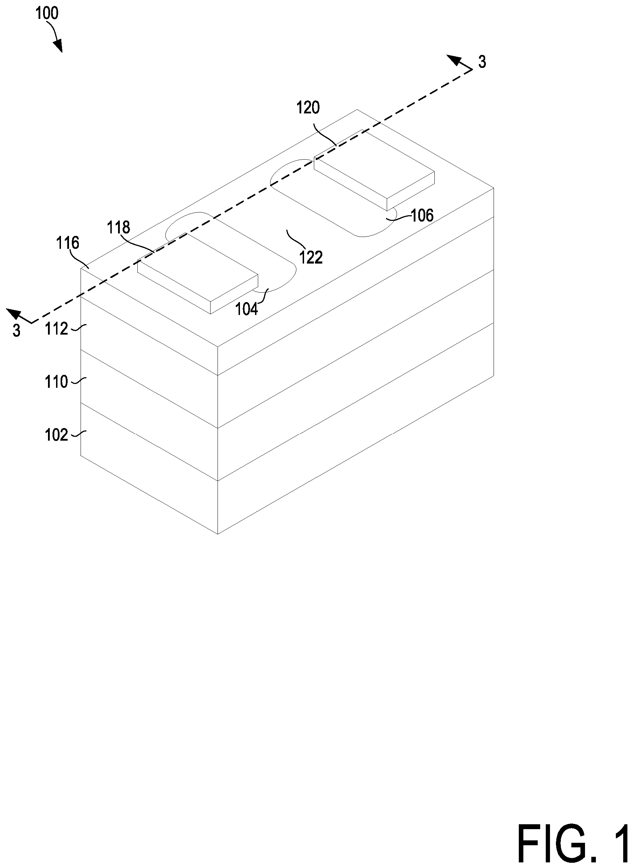

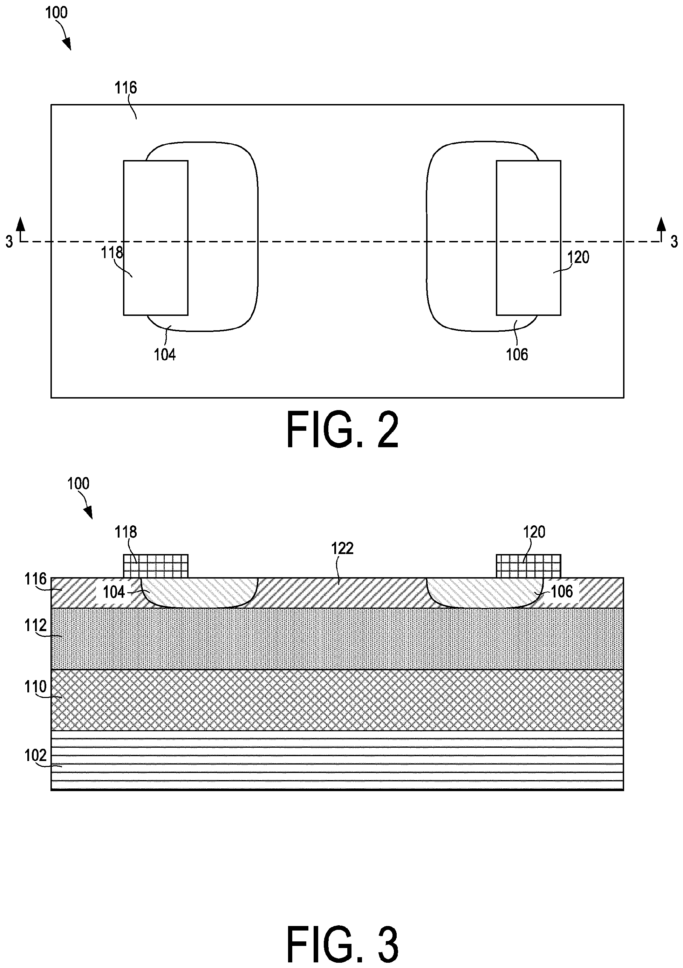

Referring now to FIGS. 1-3, in one embodiment, FIG. 1 shows a perspective view of a transistor 100, FIG. 2 shows a top-down view of the transistor 100, and FIG. 3 shows a cross-sectional view of the transistor 100. The transistor 100 is supported by a substrate 102 and a barrier layer 110. A ferroelectric layer 112 is adjacent the barrier layer 110. As described in more detail above, the barrier layer 110 prevents oxygen from reaching the substrate 102, preventing formation of oxides, such as silicon monoxide (SiO) for a silicon substrate 102. A semiconductor layer 116 is on top of the ferroelectric layer 112. A source region 104, a drain region 106, and a channel region 122 are defined in the semiconductor layer 116. A source electrode 118 is positioned on top of the source region 104, and a drain electrode 120 is positioned on top of the drain region 106. In an illustrative embodiment, the barrier layer 110 is conductive and also acts as a gate layer 110. In other embodiments, an additional gate layer may be present between the barrier layer 110 and the ferroelectric layer 112.

In use, a voltage can be applied to the gate 110 by one or more electrodes (not shown in FIGS. 1-3), which causes an electric field to be applied to the ferroelectric layer 112 and to the channel 122. In the illustrative embodiment, if the applied voltage causes an electric field above a coercive field, the direction of the spontaneous polarization of the ferroelectric material 112 can switch. The electric displacement of the ferroelectric material is the spontaneous polarization of the ferroelectric when no electric field is applied by the gate 110. Under the applied field from the voltage of the gate 110, the electric displacement of the ferroelectric material increases. As a result, the electric displacement applied to the channel 122 is affected by the polarization state of the ferroelectric material of the ferroelectric layer 112, and, therefore, the current through the channel 122 is affected by the polarization state of the ferroelectric material of the ferroelectric layer 112. This property can be used to facilitate low-threshold switching, single transistor memory, and compute-in-memory.

In the illustrative embodiment, the substrate 102 is silicon. In other embodiments, the substrate 102 may be, e.g., silicon oxide, gallium nitride, a perovskite, etc. The barrier layer 110 may be any suitable material on which the semiconductor layer 116 may be grown. In an illustrative embodiment, the barrier layer 110 is titanium nitride. An illustrative barrier layer 110 may contain 40-60% titanium by number of atoms and 40-60% nitrogen by number of atoms. The illustrative barrier layer 110 of titanium nitride has a face-centered cubic crystal structure, which is also the crystal structure of a silicon substrate 102. The illustrative barrier layer 110 of titanium nitride has a lattice constant of 0.424 nanometers, which is 22% smaller than the lattice constant of a silicon substrate 102, which has a lattice constant of 0.543 nanometers. In order to have low stress and a low number of defects, the barrier layer 110 of titanium nitride is grown on the substrate 102 of silicon using domain matching epitaxy. In particular, nine unit cells of the titanium nitride, with a size of 3.816 nanometers, matches well with seven unit cells of the silicon, with a size of 3.801 nanometers. The resulting mismatch in such a domain is less than 1%. The barrier layer 110 may have any suitable thickness, such as 10-50 nanometers or more.

A perovskite material is any crystalline material with a crystal structure similar to calcium titanate (CaTiO₃), typically with the chemical formula of ABX₃, where A is one element, B is a second element, and X is a third element. In some cases, some of one (or more) of element A, B, or X in a perovskite material may be replaced by a different element. For example, in one embodiment, Pb(Zr*ₓ*Ti_{1-*x*})O₃ (i.e., lead zirconate titanate or PZT) can have both zirconium and titanium as element B, with a varying amount of each depending on the value of *x.* A perovskite material may have various cation pairings, such as A⁺B²⁺X⁻₃, A²⁺B⁴⁺X²⁻₃, A³⁺B³⁺X²⁻₃, or A⁺B⁵⁺X²⁻₃.

In the illustrative embodiment, the source electrode 118, the drain electrode 120, and/or a gate layer between the barrier layer 110 and the ferroelectric layer 112 is a metallic perovskite, such as lanthanum strontium manganite (La₁₋ₓSrₓMnO₃ or LSMO), lanthanum strontium cobalt oxide (La₁₋ₓSrₓCoO₃ or LSCO), strontium ruthenate (SrRuO₃ or SRO), SrVO₃, SrCrO₃, SrFeO₃, ReO₃, CaRuO₃, SrMoO₃, SrNbO₃, LaNiO₃, etc. In other embodiments, the gate layer, the source electrode 118, and/or the drain electrode 120 may be other materials, such as platinum, iridium, copper, aluminum, or other metal, oxides with high electric conductivity that do not have the perovskite structure including RuO₂, IrO₂, and ITO, polysilicon, etc. In some embodiments, the work function of a gate layer is selected to shift the coercive voltage across the ferroelectric layer 112. The gate layer may have any suitable thickness, such as 10-50 nanometers or more. The gate may be referred to as the gate layer, gate electrode, etc.

The ferroelectric layer 112 may be any suitable ferroelectric, such as a perovskite ferroelectric. In the illustrative embodiment, the ferroelectric layer 112 may be barium titanate (BaTiO₃ or BTO) or bismuth ferrite (BiFeO₃ or BFO). In other embodiments, the ferroelectric layer 112 may be a different material, such as lead zirconate titanate (Pb(ZrₓTi₁₋ₓ)O₃ or PZT), lead niobate zirconate titanate ((Pb₁₋ₓNbₓ)(Zr_{1-y}Ti_{y})O₃ or PNZT), lead lanthanum zirconate titanate ((Pb₁₋ₓLaₓ)(Zr_{1-y}Ti_{y})O₃ or PLZT), lanthanum bismuth ferrite (LaₓBi₁₋ₓFeO₃ or LaBFO), bismuth iron cobaltate (BiFe₁₋ₓCoₓO₃), lithium or potassium niobate (LiNbO₃ or KNbO₃), CaNbTi₂O₆, Pb₂BiNbO₆, Ca₃Nb₂N₂O₅, Bi₄Ti₃O₁₂, (BaSr)TiO₃, Ba(ZrTi)O₃, Ba(Hf,Ti)O₃, (Ba,Ca)(ZrTi)O₃, GdFeO₃, (Gd,La)FeO₃, etc. The ferroelectric layer 112 may have any suitable thickness, such as 10-50 nanometers.

In some embodiments, the layer 112 may be a dielectric layer with two or more sublayers, such as a linear dielectric layer and a ferroelectric layer. The linear dielectric layer may facilitate lattice matching for the ferroelectric and/or may reduce leakage current between the channel 122 and the gate layer.

The semiconductor layer 116 may be made from any suitable material, such as a doped perovskite. In the illustrative example, the semiconductor layer 116 is made from lanthanum-doped barium stannate (La-BaSnO₃). The source region 104 and drain region 106 may be doped relatively strongly, and the channel 122 may be doped relatively lightly. In the illustrative embodiment, the transistor 100 is symmetric, and there is no functional distinction between the source region 104 and the drain region 106. The semiconductor layer 116 may have any suitable thickness, such as 10-50 nanometers.

It should be appreciated that the approaches described above in regard to the transistor 100 can be similarly applied to other transistors, such as top-gate transistors or finFET transistors, double-gate or tri-gate transistors, ribbon FET transistors, etc. More generally, such a barrier layer 110 may be used at any suitable interface. For example, in some embodiments, a barrier layer similar to or the same as the barrier layer 110 may be adjacent any suitable interface of any layer described herein, including the ferroelectric layer 112, a gate, the semiconductor layer 116, etc. In some embodiments, the barrier layer 110 may be adjacent any suitable material including ruthenium in order to prevent migration of the ruthenium, including any material described herein that includes ruthenium.

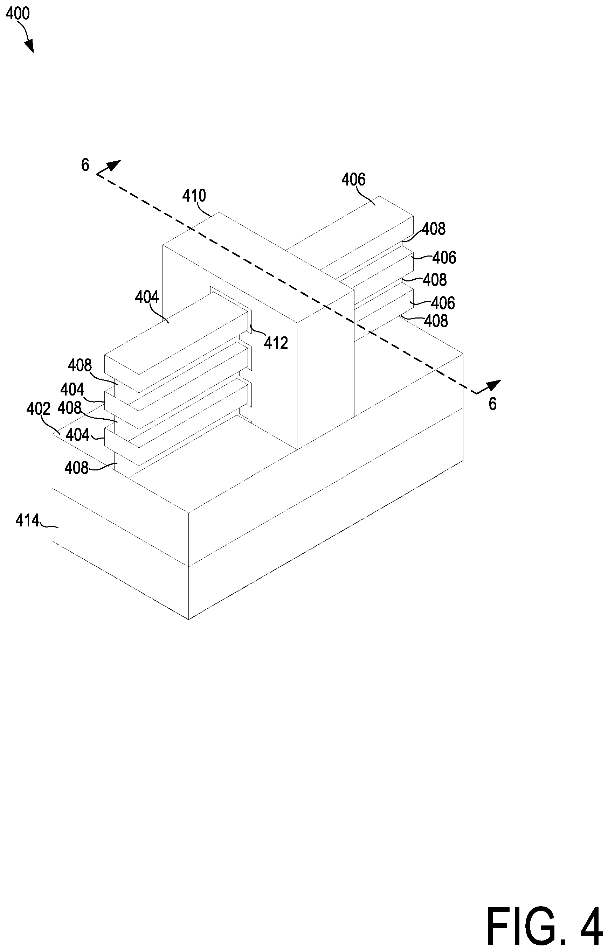

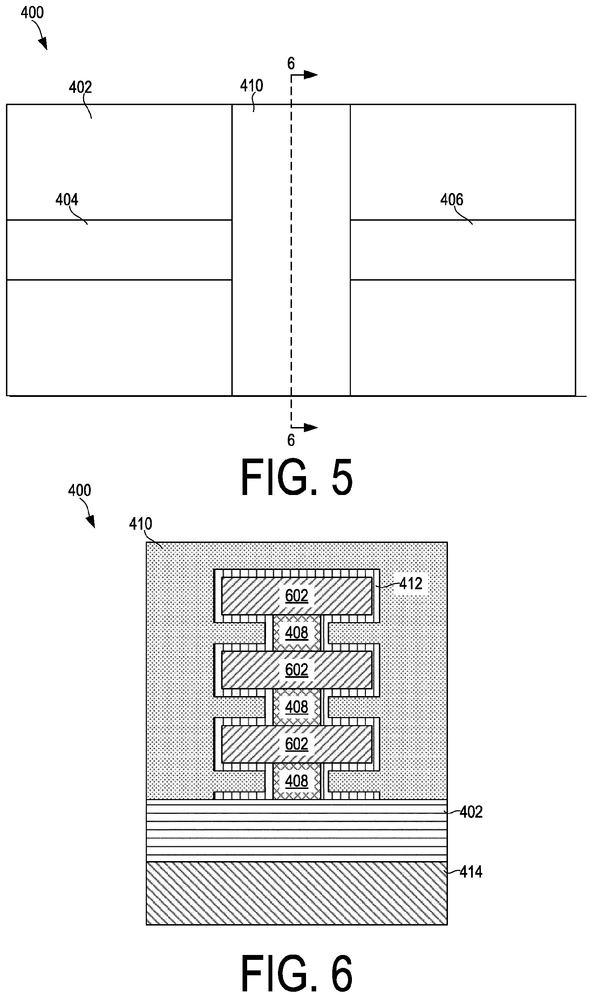

Referring now to FIGS. 4-6, in one embodiment, FIG. 4 shows a perspective view of a ribbon FET 400, FIG. 5 shows a top-down view of the ribbon FET 400, and FIG. 6 shows a cross-sectional view of the ribbon FET 400. The ribbon FET 400 may also be referred to as a gate-all-around transistor, a nanowire transistor, a nanosheet transistor, etc. The ribbon FET 400 has one or more source fins 404 and one or more drain fins 406. Spacers 408 may be interleaved with the fins 404, 406. A ferroelectric layer 412 surrounds a channel region 602 of the fins 404, 406 (see FIG. 6). A gate 410 partially or fully surrounds the ferroelectric layer 412. The transistor 400 is grown on a substrate 414, with a barrier layer 402 adjacent the substrate 414.

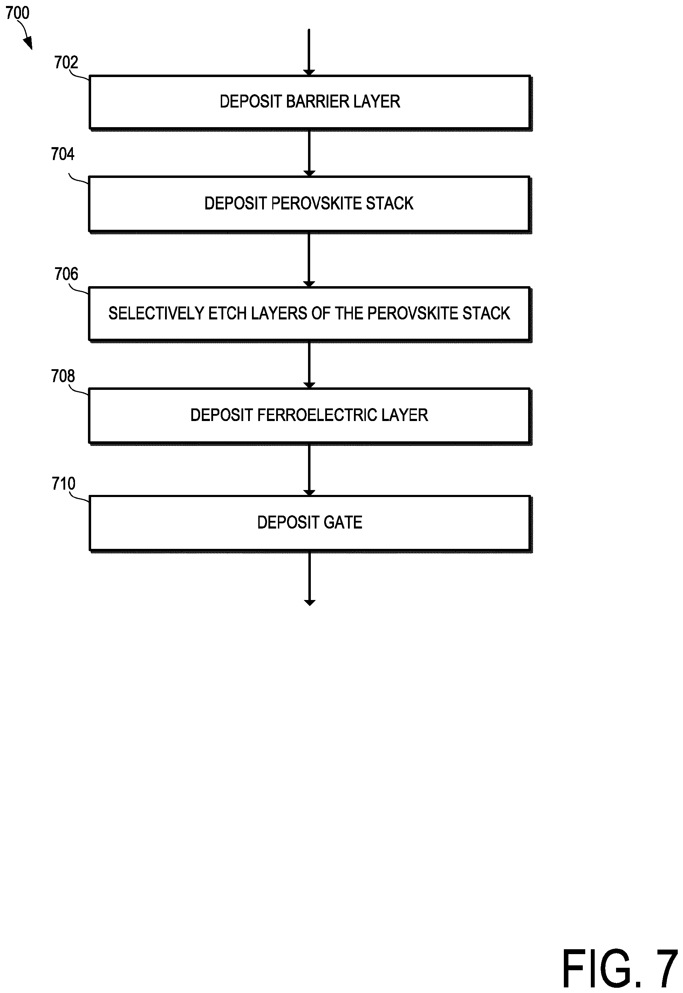

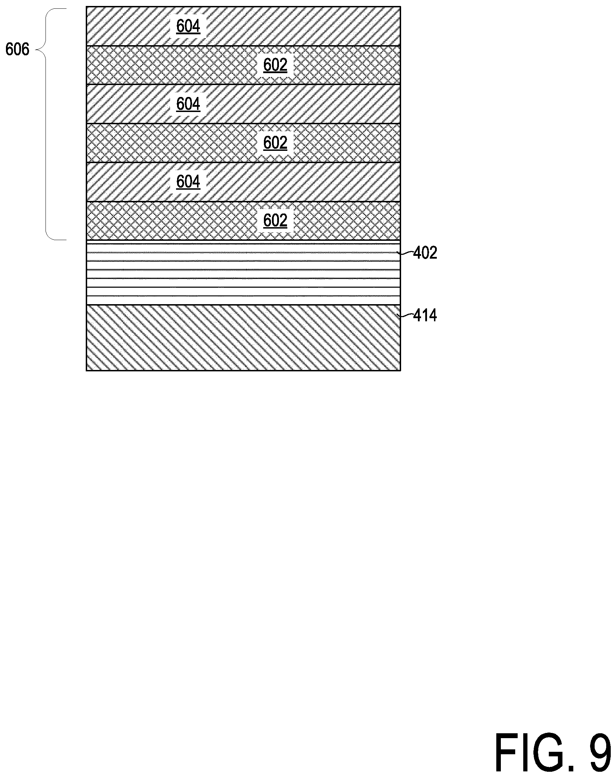

In the illustrative embodiment and as described below in more detail in regard to FIG. 7, the source fins 404, the drain fins 406, and the channel 602 are made of a doped semiconductor, and the spacers 408 are made from the same semiconductor without doping or are made from an insulator. The source fins 404, the drain fins 406, the channel 602, and the spacer 408 may be grown in alternating layers as a stack, as shown in FIG. 9. The alternation of layers of similar material allows for growth of high-quality crystals, leading to high electron mobility. The undoped semiconductor or insulator can be preferentially etched, forming the fins 404, 406 and leaving spacers 408. The transistor 400 may work in a similar manner as the transistor 100, with the ferroelectric layer 412 reducing the switching voltage of the transistor 400.

The substrate 414 supports the barrier layer 402 and the rest of the transistor 400. In the illustrative embodiment, the substrate 414 is silicon. In other embodiments, the substrate 414 may be, e.g., silicon oxide, gallium nitride, a perovskite, etc.

The barrier layer 402 may be any suitable material on which the other components of the transistor 400 may be grown. In an illustrative embodiment, the barrier layer 402 is titanium nitride, as discussed above in more detail, a description of which will not be repeated in the interest of clarity.

The source fins 404, the drain fins 406, and the channel 602 may be made from any suitable material, such as a doped perovskite. In the illustrative example, the source fins 404, the drain fins 406, and the channel 602 are made from lanthanum-doped barium stannate (La-BaSnO₃). In other embodiments, the source fins 404, the drain fins 406, and the channel 602 may be made from other materials, such as lanthanum-doped SrSnO₃ or lanthanum-doped (BaSr)SnO₃. In some embodiments, additionally or alternatively, the source fins 404, the drain fins 406, and the channel 602 may be doped with a different element, such as Nd, Ce, Cs, Y, V, K, Co, etc. The source fins 404 and drain fins 406 may be doped relatively strongly, and the channel 602 may be doped relatively lightly. In the illustrative embodiment, the transistor 400 is symmetric, and there is no functional distinction between the source 404 and the drain 406. The source fins 404, the drain fins 406, and the channel 602 may have any suitable dimensions, such as a thickness or width of, e.g., 0.5-20 nanometers and a length of, e.g., 2-50 nanometers. The transistor may include and suitable number of source fins 404 and drain fins 406, such as 1-5.

The spacers 408 may be made from any material with a lattice parameter that is close to that of the source fins 404, the drain fins 406, and the channel 602, such as a lattice parameter within 3% of the source fins 404, the drain fins 406, and the channel 602. In the illustrative embodiment, the source fins 404, the drain fins 406, and the channel 602 are made from a doped material (e.g., lanthanum-doped barium stannate), and the spacers 408 are made from the corresponding undoped material (e.g., undoped barium stannate). In other embodiments, the source fins 404, the drain fins 406, and the channel 602 may be lanthanum-doped barium stannate, and the layers 408 may be made from, e.g., relatively lightly doped barium stannate (BaSnO₃), SrTiO₃, SrRuO₃, (SrBa)RuO₃, ReScO₃ (where Re may be Dy, Tb, Gd, Eu, Sm, Nd, Pr, Ce, or La), LaLuO₃, La(LuSc)O₃, BaHfO₃, BaZrO₃, LaAlO₃, LaCoO₃, SrSnO₃, Ba2ScNbO₆, SrZrO₃, SrHfO₃, LaInO₃, MgO, (Sr,Ba)SnO₃, etc. In some embodiments, the spacers 408 may be a material with a lattice constant that applies a small amount of tensile strain on the source fins 404, the drain fins 406, and the channel 602, which may increase electron mobility.

The ferroelectric layer 412 may be any suitable ferroelectric, such as a perovskite ferroelectric. In the illustrative embodiment, the ferroelectric layer 412 may be barium titanate (BaTiO₃ or BTO) or bismuth ferrite (BiFeO₃ or BFO). In other embodiments, the ferroelectric layer 412 may be a different material, such as lead zirconate titanate (Pb(ZrₓTi₁₋ₓ)O₃ or PZT), lead niobate zirconate titanate ((Pb₁₋ₓNbₓ)(Zri-_{y}Ti_{y})O₃ or PNZT), lead lanthanum zirconate titanate ((Pb₁₋ₓLaₓ)(Zr_{1-y}Ti_{y})O₃ or PLZT), lanthanum bismuth ferrite (LaₓBi₁₋ₓFeO₃ or LaBFO), bismuth iron cobaltate (BiFe₁₋ₓCoₓO₃), lithium or potassium niobate (LiNbO₃ or KNbO₃), CaNbTi₂O₆, Pb₂BiNbO₆, Ca₃Nb₂N₂O₅, Bi₄Ti₃O₁₂, Ba(Hf,Ti)O₃, (Ba,Ca)(ZrTi)O₃, GdFeO₃, (Gd,La)FeO₃, etc. In some embodiments, an interlayer may be between the channel 602 and the ferroelectric layer 412, as described below in regard to FIGS. 9-11.

The ferroelectric layer 412 may have any suitable coercive field, such as 50-500 kV/cm. The ferroelectric layer 412 may be any suitable thickness. The ferroelectric layer 412 may have any suitable thickness, such as a thickness of about 0.5-25 nanometers.

The threshold voltage of the transistor 400 depends on the ferroelectric layer 412 material as well as the channel 602 thickness and doping concentration. The threshold voltage of the transistor 400 may be any suitable value, such as 0.2-5 volts, depending on the materials used.

In some embodiments, the polarization of the ferroelectric of the ferroelectric layer 412 switches all at once in a few picoseconds. In other embodiments, the ferroelectric of the ferroelectric layer 412 may have multiple domains that may switch at different applied electric fields (and, therefore, at different times). In such embodiments, the ferroelectric of the ferroelectric layer 412 may have multiple stable states that can be set by applying a particular voltage to the gate 410. Such a transistor 400 can act as a multi-level memory or like an analog memory.

The illustrative gate 410 is a metallic perovskite, such as strontium ruthenate (SrRuO₃ or SRO), lanthanum strontium manganite (La₁₋ₓSrₓMnO₃ or LSMO), lanthanum strontium cobalt oxide (La₁₋ₓSrₓCoO₃ or LSCO), SrVO₃, SrCrO₃, SrFeO₃, ReO₃, CaRuO₃, SrMoO₃, SrNbO₃, LaNiO₃, etc. In other embodiments, the gate 410 may be other materials, such as platinum, iridium, copper, aluminum, or other metal, oxides with high electric conductivity that do not have the perovskite structure including RuO₂, IrO₂, and ITO, polysilicon, etc. In some embodiments, the work function of the gate 410 is selected to shift the coercive voltage across the ferroelectric layer 412. In some embodiments, the gate 410 may be the same material as the barrier layer 402, such as titanium nitride.

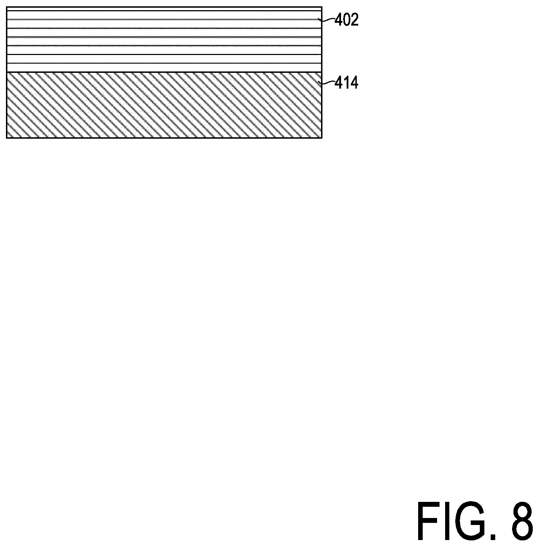

Referring now to FIG. 7, in one embodiment, a flowchart for a method 700 for creating a transistor (such as transistor 400) is shown. The method 700 may be executed by a technician and/or by one or more automated machines. In some embodiments, one or more machines may be programmed to do some or all of the steps of the method 700. Such a machine may include, e.g., a memory, a processor, data storage, etc. The memory and/or data storage may store instructions that, when executed by the machine, causes the machine to perform some or all of the steps of the method 700. The method 700 may use any suitable set of techniques that are used in semiconductor processing, such as chemical vapor deposition, atomic layer deposition, physical vapor deposition, molecular beam epitaxy, pulsed laser deposition, layer transfer, photolithography, ion implantation, dry etching, wet etching, thermal treatments, etc. In some embodiments, some or all steps of the method 700 may be performed at the wafer level, the die level, and/or the package level, as appropriate. FIGS. 8-11 show various stages of the method 700 as it is used to create a transistor. In some embodiments, some or all of the layers deposited as part of the method 700 may be deposited epitaxially in order to provide high-quality layers with low defect density.

The method 700 begins in block 702, in which a barrier layer 402 is deposited on a substrate 414, as shown in FIG. 8. The barrier layer 402 may be deposited in any suitable manner. In an illustrative embodiment, domain matching epitaxy is used to deposit the barrier layer 402 on the substrate 414.

In block 704, a perovskite stack 606 is applied. In the illustrative embodiment, the perovskite stack 606 includes alternating layers of lanthanum-doped barium stannate layers 604 and undoped barium stannate layers 602. In some embodiments, different parts of the lanthanum-doped barium stannate layers 604 may have different densities of dopants. For example, the regions of the lanthanum-doped barium stannate layers 604 that will become source fins 404 and drain fins 406 may have a higher dopant concentration, and layers that will become the channel 602 may have a lower dopant concentration. In other embodiments, the stack 606 may include lanthanum-doped barium stannate layers 604 alternating with layers 602 made from, e.g., relatively lightly doped barium stannate (e.g., 0-20% of the dopant concentration as the layers 604), SrTiO₃, SrRuO₃, (SrBa)RuO₃, ReScO₃ (where Re may be Dy, Tb, Gd, Eu, Sm, Nd, Pr, Ce, or La), LaLuO₃, La(LuSc)O₃, BaHfO₃, BaZrO₃, LaAlO₃, LaCoO₃, SrSnO₃, Ba2ScNbO₆, SrZrO₃, SrHfO₃, LaInO₃, MgO, (Sr,Ba)SnO₃, etc. In the illustrative embodiment, the lattice parameter for the layers 604 closely matches that for the layers 602. As such, the layers 604 can be grown as high-quality crystals with relatively few defects and high electron mobility. In some embodiments, the layers 602 may be a material with a lattice constant that applies a small amount of tensile strain on the layers 604, which may increase electron mobility in the layers 604. The layers 602, 604 may be grown in any suitable manner, such as chemical vapor deposition, atomic layer deposition, physical vapor deposition, molecular beam epitaxy, pulsed laser deposition, etc. In some embodiments, the stack 606 may include one, some, or all layers that are not perovskites.

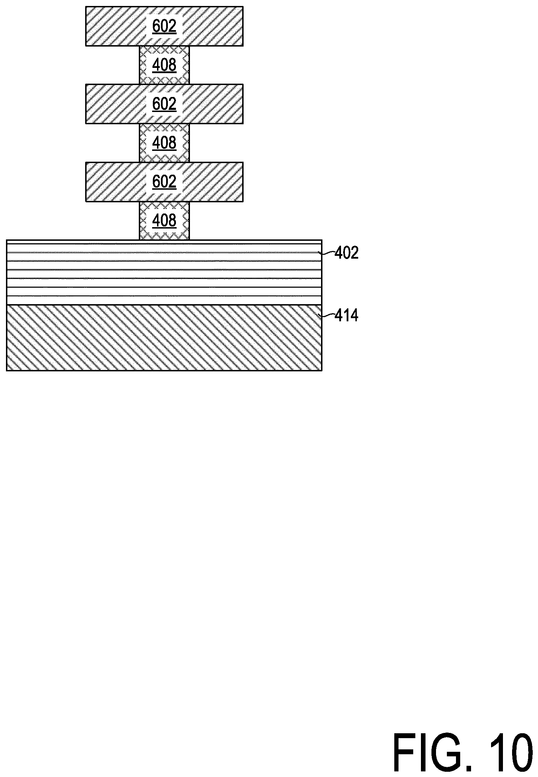

In block 706, the layers 602 are preferentially etched while leaving more or substantially all of the layers 604 intact, resulting in the structure shown in FIG. 10. At the point where the cross-section is taken, the layers 604 will be used as the channel 602. At other points, a cross-section may show where the layers 604 will be used as source fins 404 or drain fins 406. In the illustrative embodiment, the layers 602 are etched with, e.g., hydrogen fluoride. If the layers 602 are undoped barium stannate and the layers 604 are lanthanum-doped barium stannate, the lanthanum may slow the etching rate for the layers 604, allowing the layers 602 to be preferentially etched. In other embodiments, a different etchant or etching technique may be used to preferentially remove the layers 602.

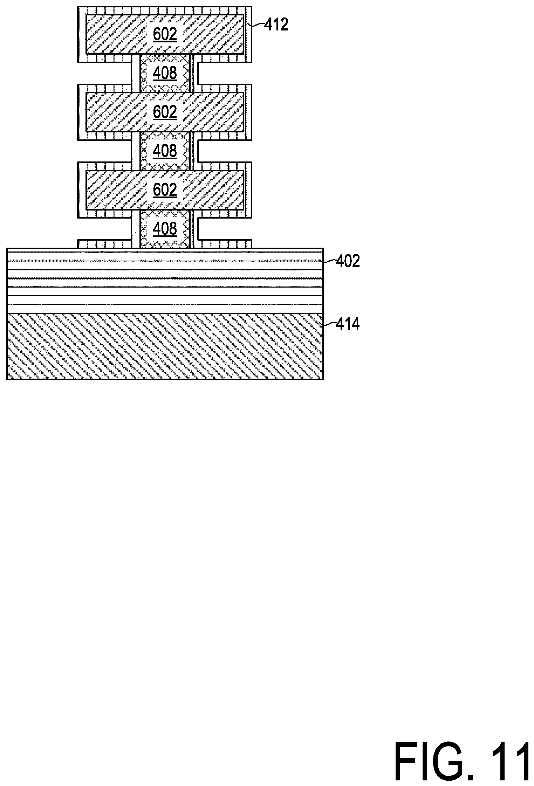

In block 708, the ferroelectric layer 412 is deposited on the channel 602, the source fins 404, the drain fins 406, and the layers 408, as shown in FIG. 11. In the illustrative embodiment, the ferroelectric layer 412 may be barium titanate (BaTiO₃ or BTO) or bismuth ferrite (BiFeO₃ or BFO). In other embodiments, the ferroelectric layer 412 may be a different material, such as lead zirconate titanate (Pb(ZrₓTi₁₋ₓ)O₃ or PZT), lead niobate zirconate titanate ((Pb₁₋ₓNbₓ)(Zr_{1-y}Ti_{y})O₃ or PNZT), lead lanthanum zirconate titanate ((Pb₁₋ₓLaₓ)(Zr_{1-y}Ti_{y})O₃ or PLZT), lanthanum bismuth ferrite (LaₓBi₁₋ₓFeO₃ or LaBFO), bismuth iron cobaltate (BiFe₁₋ₓCoₓO₃), lithium or potassium niobate (LiNbO₃ or KNbO₃), CaNbTi₂O₆, Pb₂BiNbO₆, Ca₃Nb₂N₂O₅, Bi₄Ti₃O₁₂, (BaSr)TiO₃, Ba(ZrTi)O₃, Ba(Hf,Ti)O₃, (Ba,Ca)(ZrTi)O₃, GdFeO₃, (Gd,La)FeO₃, etc.

In block 710, a gate 410 is deposited over the ferroelectric layer 412, as shown in FIGS. 4-6. The illustrative gate 410 is a metallic perovskite, such as strontium ruthenate (SrRuO₃ or SRO), lanthanum strontium manganite (La₁₋ₓSrₓMnO₃ or LSMO), lanthanum strontium cobalt oxide (La₁₋ₓSrₓCoO₃ or LSCO), SrVO₃, SrCrO₃, SrFeO₃, ReO₃, CaRuO₃, SrMoO₃, SrNbO₃, LaNiO₃, etc. In other embodiments, the gate 410 may be other materials, such as platinum, iridium, copper, aluminum, or other metal, oxides with high electric conductivity that do not have the perovskite structure including RuO₂, IrO₂, and ITO, polysilicon, etc. In some embodiments, the gate 410 may be the same material as the barrier layer 402, which may be titanium nitride.

It should be appreciated that the method 700 is one of many possible embodiments of manufacturing the transistor 400. Different approaches or orders of steps are envisioned as well. The steps of the method 700 may be done in a different order or the method 700 may include different steps for different embodiments of the transistor 400. For example, one step that is not shown is depositing source and drain electrodes. It should be appreciated that a complete manufacturing process of an integrated circuit that includes the transistor 400 may include steps not shown in the method 700, such as cleaning, surface passivation, creating interconnects, packaging, etc. In some embodiments, the layers 602 may be fully removed around the channel 602, allowing the gate 410 to wrap around the channel 602 more fully. In some embodiments, the layers 602 may be fully removed around the source fins 404 and drain fins 406 as well as the channel 602. In such embodiments, one or more other layers may support the source fins 404, the channel 602, and the drain fins 106 while the layers 602 are removed. More generally, the method 700 may be adapted to create any suitable transistor with a barrier layer, such as the transistor 100.

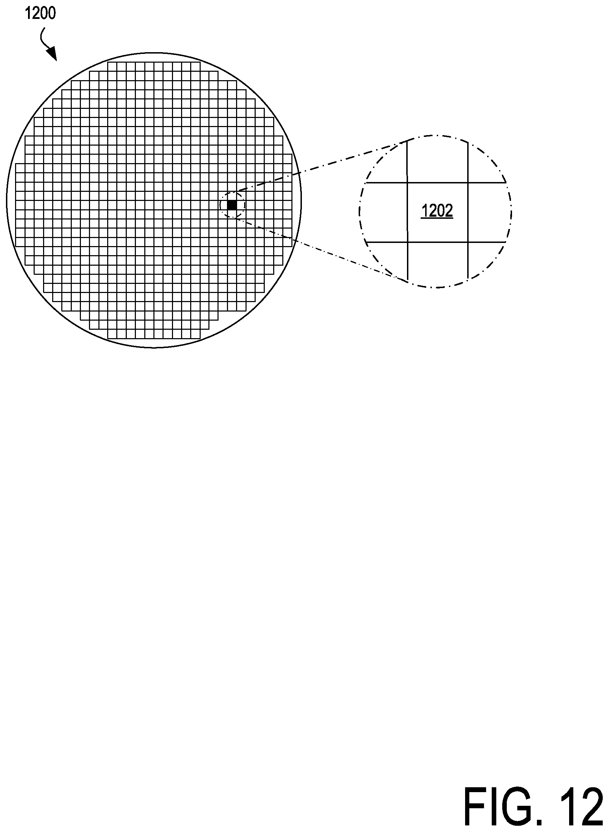

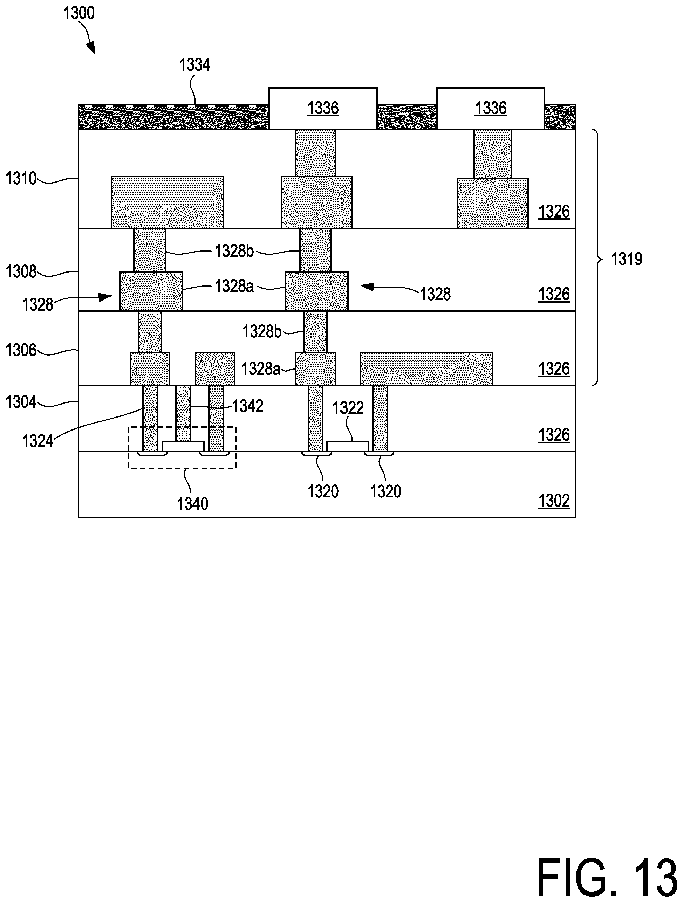

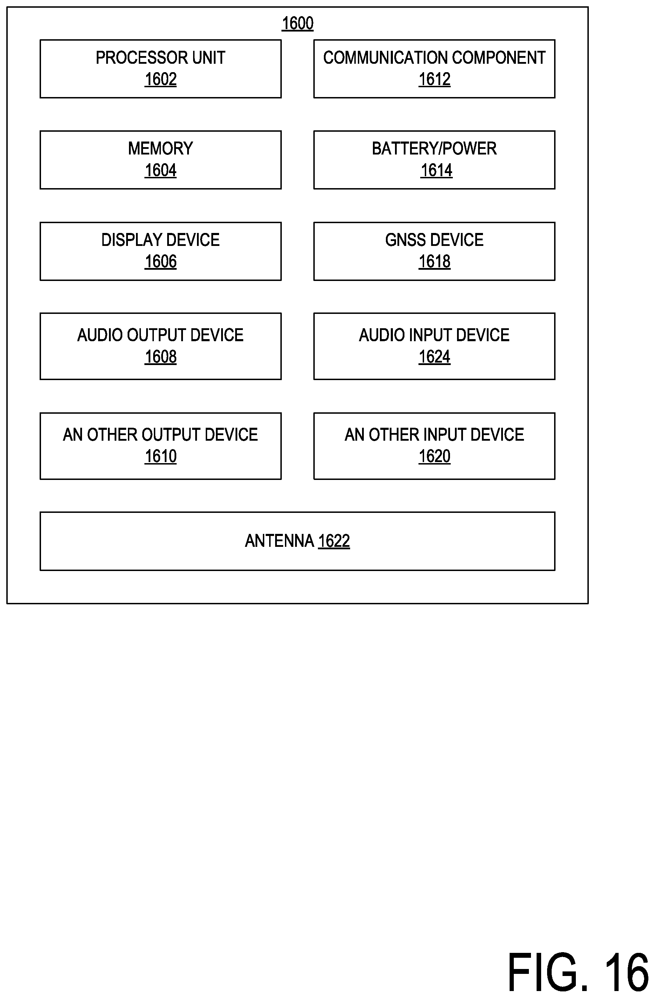

FIG. 12 is a top view of a wafer 1200 and dies 1202 that may include any of the transistors 100, 400 disclosed herein. The wafer 1200 may be composed of semiconductor material and may include one or more dies 1202 having integrated circuit structures formed on a surface of the wafer 1200. The individual dies 1202 may be a repeating unit of an integrated circuit product that includes any suitable integrated circuit. After the fabrication of the semiconductor product is complete, the wafer 1200 may undergo a singulation process in which the dies 1202 are separated from one another to provide discrete "chips" of the integrated circuit product. The die 1202 may include one or more transistors (e.g., some of the transistors 1340 of FIG. 13, discussed below), supporting circuitry to route electrical signals to the transistors, passive components (e.g., signal traces, resistors, capacitors, or inductors), and/or any other integrated circuit components. In some embodiments, the wafer 1200 or the die 1202 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1202. For example, a memory array formed by multiple memory devices may be formed on a same die 1202 as a processor unit (e.g., the processor unit 1602 of FIG. 16) or other logic that is configured to store information in the memory devices or execute instructions stored in the memory array. Various ones of the transistors 100, 400 disclosed herein may be manufactured using a die-to-wafer assembly technique in which some dies are attached to a wafer 1200 that include others of the dies, and the wafer 1200 is subsequently singulated.

FIG. 13 is a cross-sectional side view of an integrated circuit device 1300 that may include any of the transistors 100, 400 disclosed herein. One or more of the integrated circuit devices 1300 may be included in one or more dies 1202 (FIG. 12). The integrated circuit device 1300 may be formed on a die substrate 1302 (e.g., the wafer 1200 of FIG. 12) and may be included in a die (e.g., the die 1202 of FIG. 12). The die substrate 1302 may be a semiconductor substrate composed of semiconductor material systems including, for example, n-type or p-type materials systems (or a combination of both). The die substrate 1302 may include, for example, a crystalline substrate formed using a bulk silicon or a silicon-on-insulator (SOI) substructure. In some embodiments, the die substrate 1302 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1302. Although a few examples of materials from which the die substrate 1302 may be formed are described here, any material that may serve as a foundation for an integrated circuit device 1300 may be used. The die substrate 1302 may be part of a singulated die (e.g., the dies 1202 of FIG. 12) or a wafer (e.g., the wafer 1200 of FIG. 12).

The integrated circuit device 1300 may include one or more device layers 1304 disposed on the die substrate 1302. The device layer 1304 may include features of one or more transistors 1340 (e.g., metal oxide semiconductor field-effect transistors (MOSFETs)) formed on the die substrate 1302. The transistors 1340 may include, for example, one or more source and/or drain (S/D) regions 1320, a gate 1322 to control current flow between the S/D regions 1320, and one or more S/D contacts 1324 to route electrical signals to/from the S/D regions 1320. The transistors 1340 may include additional features not depicted for the sake of clarity, such as device isolation regions, gate contacts, and the like. The transistors 1340 are not limited to the type and configuration depicted in FIG. 13 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

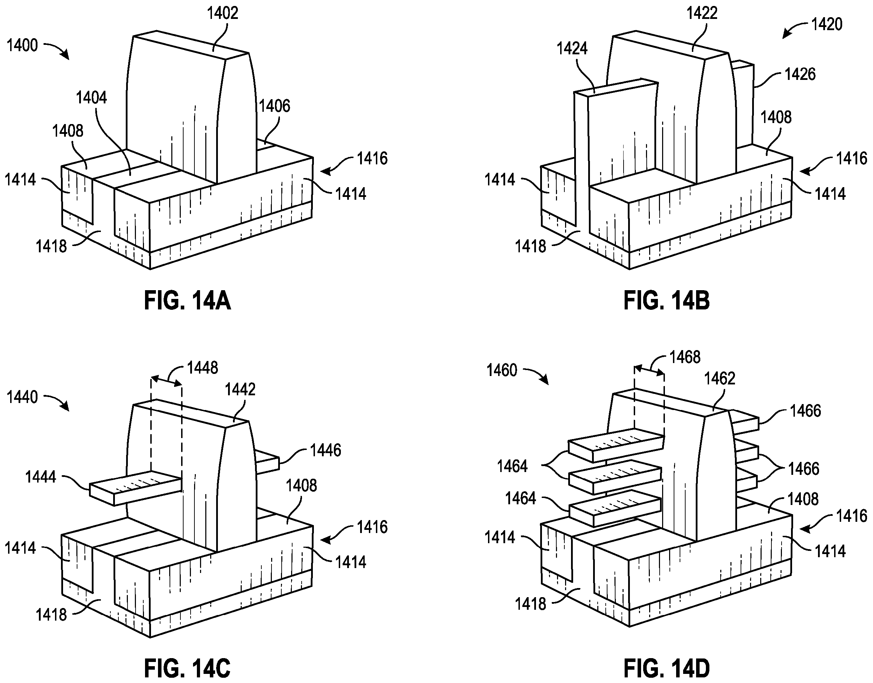

FIGS. 14A-14D are simplified perspective views of example planar, FinFET, gate-all-around, and stacked gate-all-around transistors. The transistors illustrated in FIGS. 14A-14D are formed on a substrate 1416 having a surface 1408. Isolation regions 1414 separate the source and drain regions of the transistors from other transistors and from a bulk region 1418 of the substrate 1416.

FIG. 14A is a perspective view of an example planar transistor 1400 comprising a gate 1402 that controls current flow between a source region 1404 and a drain region 1406. The transistor 1400 is planar in that the source region 1404 and the drain region 1406 are planar with respect to the substrate surface 1408.

FIG. 14B is a perspective view of an example FinFET transistor 1420 comprising a gate 1422 that controls current flow between a source region 1424 and a drain region 1426. The transistor 1420 is non-planar in that the source region 1424 and the drain region 1426 comprise "fins" that extend upwards from the substrate surface 1428. As the gate 1422 encompasses three sides of the semiconductor fin that extends from the source region 1424 to the drain region 1426, the transistor 1420 can be considered a tri-gate transistor. FIG. 14B illustrates one S/D fin extending through the gate 1422, but multiple S/D fins can extend through the gate of a FinFET transistor.

FIG. 14C is a perspective view of a gate-all-around (GAA) transistor 1440 comprising a gate 1442 that controls current flow between a source region 1444 and a drain region 1446. The transistor 1440 is non-planar in that the source region 1444 and the drain region 1446 are elevated from the substrate surface 1428.

FIG. 14D is a perspective view of a GAA transistor 1460 comprising a gate 1462 that controls current flow between multiple elevated source regions 1464 and multiple elevated drain regions 1466. The transistor 1460 is a stacked GAA transistor as the gate controls the flow of current between multiple elevated S/D regions stacked on top of each other. The transistors 1440 and 1460 are considered gate-all-around transistors as the gates encompass all sides of the semiconductor portions that extends from the source regions to the drain regions. The transistors 1440 and 1460 can alternatively be referred to as nanowire, nanosheet, or nanoribbon transistors depending on the width (e.g., widths 1448 and 1468 of transistors 1440 and 1460, respectively) of the semiconductor portions extending through the gate.

Returning to FIG. 13, a transistor 1340 may include a gate 1322 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1340 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1340 along the source-channel-drain direction, the gate electrode may consist of a U-shaped structure that includes a bottom portion substantially parallel to the surface of the die substrate 1302 and two sidewall portions that are substantially perpendicular to the top surface of the die substrate 1302. In other embodiments, at least one of the metal layers that form the gate electrode may simply be a planar layer that is substantially parallel to the top surface of the die substrate 1302 and does not include sidewall portions substantially perpendicular to the top surface of the die substrate 1302. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1320 may be formed within the die substrate 1302 adjacent to the gate 1322 of individual transistors 1340. A gate electrode 1342 may be connected to the gate 1322. The S/D regions 1320 may be formed using an implantation/diffusion process or an etching/deposition process, for example. In the former process, dopants such as boron, aluminum, antimony, phosphorous, or arsenic may be ion-implanted into the die substrate 1302 to form the S/D regions 1320. An annealing process that activates the dopants and causes them to diffuse farther into the die substrate 1302 may follow the ion-implantation process. In the latter process, the die substrate 1302 may first be etched to form recesses at the locations of the S/D regions 1320. An epitaxial deposition process may then be carried out to fill the recesses with material that is used to fabricate the S/D regions 1320. In some implementations, the S/D regions 1320 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1320 may be formed using one or more alternate semiconductor materials such as germanium or a group III-V material or alloy. In further embodiments, one or more layers of metal and/or metal alloys may be used to form the S/D regions 1320.

Electrical signals, such as power and/or input/output (I/O) signals, may be routed to and/or from the devices (e.g., transistors 1340) of the device layer 1304 through one or more interconnect layers disposed on the device layer 1304 (illustrated in FIG. 13 as interconnect layers 1306-1310). For example, electrically conductive features of the device layer 1304 (e.g., the gate 1322 and the S/D contacts 1324) may be electrically coupled with the interconnect structures 1328 of the interconnect layers 1306-1310. The one or more interconnect layers 1306-1310 may form a metallization stack (also referred to as an "ILD stack") 1319 of the integrated circuit device 1300.

The interconnect structures 1328 may be arranged within the interconnect layers 1306-1310 to route electrical signals according to a wide variety of designs; in particular, the arrangement is not limited to the particular configuration of interconnect structures 1328 depicted in FIG. 13. Although a particular number of interconnect layers 1306-1310 is depicted in FIG. 13, embodiments of the present disclosure include integrated circuit devices having more or fewer interconnect layers than depicted.

In some embodiments, the interconnect structures 1328 may include lines 1328a and/or vias 1328b filled with an electrically conductive material such as a metal. The lines 1328a may be arranged to route electrical signals in a direction of a plane that is substantially parallel with a surface of the die substrate 1302 upon which the device layer 1304 is formed. For example, the lines 1328a may route electrical signals in a direction in and out of the page and/or in a direction across the page. The vias 1328b may be arranged to route electrical signals in a direction of a plane that is substantially perpendicular to the surface of the die substrate 1302 upon which the device layer 1304 is formed. In some embodiments, the vias 1328b may electrically couple lines 1328a of different interconnect layers 1306-1310 together.

The interconnect layers 1306-1310 may include a dielectric material 1326 disposed between the interconnect structures 1328, as shown in FIG. 13. In some embodiments, dielectric material 1326 disposed between the interconnect structures 1328 in different ones of the interconnect layers 1306-1310 may have different compositions; in other embodiments, the composition of the dielectric material 1326 between different interconnect layers 1306-1310 may be the same. The device layer 1304 may include a dielectric material 1326 disposed between the transistors 1340 and a bottom layer of the metallization stack as well. The dielectric material 1326 included in the device layer 1304 may have a different composition than the dielectric material 1326 included in the interconnect layers 1306-1310; in other embodiments, the composition of the dielectric material 1326 in the device layer 1304 may be the same as a dielectric material 1326 included in any one of the interconnect layers 1306-1310.

A first interconnect layer 1306 (referred to as Metal 1 or "M1") may be formed directly on the device layer 1304. In some embodiments, the first interconnect layer 1306 may include lines 1328a and/or vias 1328b, as shown. The lines 1328a of the first interconnect layer 1306 may be coupled with contacts (e.g., the S/D contacts 1324) of the device layer 1304. The vias 1328b of the first interconnect layer 1306 may be coupled with the lines 1328a of a second interconnect layer 1308.

The second interconnect layer 1308 (referred to as Metal 2 or "M2") may be formed directly on the first interconnect layer 1306. In some embodiments, the second interconnect layer 1308 may include via 1328b to couple the lines 1328 of the second interconnect layer 1308 with the lines 1328a of a third interconnect layer 1310. Although the lines 1328a and the vias 1328b are structurally delineated with a line within individual interconnect layers for the sake of clarity, the lines 1328a and the vias 1328b may be structurally and/or materially contiguous (e.g., simultaneously filled during a dual-damascene process) in some embodiments.

The third interconnect layer 1310 (referred to as Metal 3 or "M3") (and additional interconnect layers, as desired) may be formed in succession on the second interconnect layer 1308 according to similar techniques and configurations described in connection with the second interconnect layer 1308 or the first interconnect layer 1306. In some embodiments, the interconnect layers that are "higher up" in the metallization stack 1319 in the integrated circuit device 1300 (i.e., farther away from the device layer 1304) may be thicker that the interconnect layers that are lower in the metallization stack 1319, with lines 1328a and vias 1328b in the higher interconnect layers being thicker than those in the lower interconnect layers.

The integrated circuit device 1300 may include a solder resist material 1334 (e.g., polyimide or similar material) and one or more conductive contacts 1336 formed on the interconnect layers 1306-1310. In FIG. 13, the conductive contacts 1336 are illustrated as taking the form of bond pads. The conductive contacts 1336 may be electrically coupled with the interconnect structures 1328 and configured to route the electrical signals of the transistor(s) 1340 to external devices. For example, solder bonds may be formed on the one or more conductive contacts 1336 to mechanically and/or electrically couple an integrated circuit die including the integrated circuit device 1300 with another component (e.g., a printed circuit board). The integrated circuit device 1300 may include additional or alternate structures to route the electrical signals from the interconnect layers 1306-1310; for example, the conductive contacts 1336 may include other analogous features (e.g., posts) that route the electrical signals to external components.

In some embodiments in which the integrated circuit device 1300 is a double-sided die, the integrated circuit device 1300 may include another metallization stack (not shown) on the opposite side of the device layer(s) 1304. This metallization stack may include multiple interconnect layers as discussed above with reference to the interconnect layers 1306-1310, to provide conductive pathways (e.g., including conductive lines and vias) between the device layer(s) 1304 and additional conductive contacts (not shown) on the opposite side of the integrated circuit device 1300 from the conductive contacts 1336.

In other embodiments in which the integrated circuit device 1300 is a double-sided die, the integrated circuit device 1300 may include one or more through silicon vias (TSVs) through the die substrate 1302; these TSVs may make contact with the device layer(s) 1304, and may provide conductive pathways between the device layer(s) 1304 and additional conductive contacts (not shown) on the opposite side of the integrated circuit device 1300 from the conductive contacts 1336. In some embodiments, TSVs extending through the substrate can be used for routing power and ground signals from conductive contacts on the opposite side of the integrated circuit device 1300 from the conductive contacts 1336 to the transistors 1340 and any other components integrated into the die 1300, and the metallization stack 1319 can be used to route I/O signals from the conductive contacts 1336 to transistors 1340 and any other components integrated into the die 1300.

Multiple integrated circuit devices 1300 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

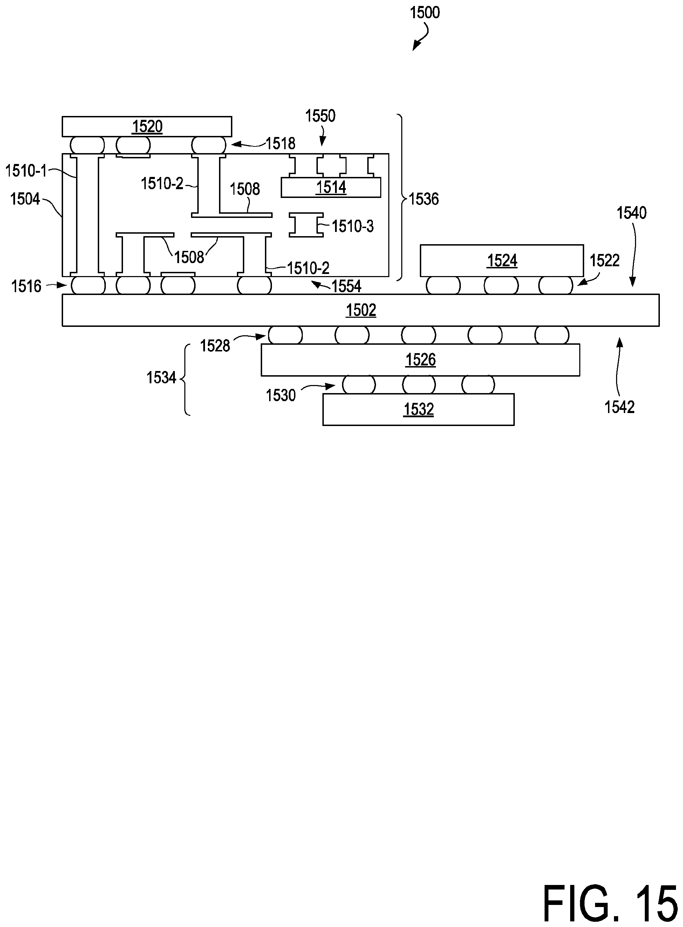

FIG. 15 is a cross-sectional side view of an integrated circuit device assembly 1500 that may include any of the transistors 100, 400 disclosed herein. The integrated circuit device assembly 1500 includes a number of components disposed on a circuit board 1502 (which may be a motherboard, system board, mainboard, etc.). The integrated circuit device assembly 1500 includes components disposed on a first face 1540 of the circuit board 1502 and an opposing second face 1542 of the circuit board 1502; generally, components may be disposed on one or both faces 1540 and 1542. Any of the integrated circuit components discussed below with reference to the integrated circuit device assembly 1500 may take the form of any suitable ones of the embodiments of the transistor 100, 400 disclosed herein.

In some embodiments, the circuit board 1502 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1502. In other embodiments, the circuit board 1502 may be a non-PCB substrate. The integrated circuit device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502, and may include solder balls (as shown in FIG. 15), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1536 may include an integrated circuit component 1520 coupled to an interposer 1504 by coupling components 1518. The coupling components 1518 may take any suitable form for the application, such as the forms discussed above with reference to the coupling components 1516. Although a single integrated circuit component 1520 is shown in FIG. 15, multiple integrated circuit components may be coupled to the interposer 1504; indeed, additional interposers may be coupled to the interposer 1504. The interposer 1504 may provide an intervening substrate used to bridge the circuit board 1502 and the integrated circuit component 1520.

The integrated circuit component 1520 may be a packaged or unpacked integrated circuit product that includes one or more integrated circuit dies (e.g., the die 1202 of FIG. 12, the integrated circuit device 1300 of FIG. 13) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1520, a single monolithic integrated circuit die comprises solder bumps attached to contacts on the die. The solder bumps allow the die to be directly attached to the interposer 1504. The integrated circuit component 1520 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1520 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1520 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1520 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1504 may spread connections to a wider pitch or reroute a connection to a different connection. For example, the interposer 1504 may couple the integrated circuit component 1520 to a set of ball grid array (BGA) conductive contacts of the coupling components 1516 for coupling to the circuit board 1502. In the embodiment illustrated in FIG. 15, the integrated circuit component 1520 and the circuit board 1502 are attached to opposing sides of the interposer 1504; in other embodiments, the integrated circuit component 1520 and the circuit board 1502 may be attached to a same side of the interposer 1504. In some embodiments, three or more components may be interconnected by way of the interposer 1504.

In some embodiments, the interposer 1504 may be formed as a PCB, including multiple metal layers separated from one another by layers of dielectric material and interconnected by electrically conductive vias. In some embodiments, the interposer 1504 may be formed of an epoxy resin, a fiberglass-reinforced epoxy resin, an epoxy resin with inorganic fillers, a ceramic material, or a polymer material such as polyimide. In some embodiments, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias 1510, including but not limited to through hole vias 1510-1 (that extend from a first face 1550 of the interposer 1504 to a second face 1554 of the interposer 1504), blind vias 1510-2 (that extend from the first or second faces 1550 or 1554 of the interposer 1504 to an internal metal layer), and buried vias 1510-3 (that connect internal metal layers).

In some embodiments, the interposer 1504 can comprise a silicon interposer. Through silicon vias (TSV) extending through the silicon interposer can connect connections on a first face of a silicon interposer to an opposing second face of the silicon interposer. In some embodiments, an interposer 1504 comprising a silicon interposer can further comprise one or more routing layers to route connections on a first face of the interposer 1504 to an opposing second face of the interposer 1504.

The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The integrated circuit device assembly 1500 may include an integrated circuit component 1524 coupled to the first face 1540 of the circuit board 1502 by coupling components 1522. The coupling components 1522 may take the form of any of the embodiments discussed above with reference to the coupling components 1516, and the integrated circuit component 1524 may take the form of any of the embodiments discussed above with reference to the integrated circuit component 1520.

The integrated circuit device assembly 1500 illustrated in FIG. 15 includes a package-on-package structure 1534 coupled to the second face 1542 of the circuit board 1502 by coupling components 1528. The package-on-package structure 1534 may include an integrated circuit component 1526 and an integrated circuit component 1532 coupled together by coupling components 1530 such that the integrated circuit component 1526 is disposed between the circuit board 1502 and the integrated circuit component 1532. The coupling components 1528 and 1530 may take the form of any of the embodiments of the coupling components 1516 discussed above, and the integrated circuit components 1526 and 1532 may take the form of any of the embodiments of the integrated circuit component 1520 discussed above. The package-on-package structure 1534 may be configured in accordance with any of the package-on-package structures known in the art.

FIG. 16 is a block diagram of an example electrical device 1600 that may include one or more of the transistor 100, 400 disclosed herein. For example, any suitable ones of the components of the electrical device 1600 may include one or more of the integrated circuit device assemblies 1500, integrated circuit components 1520, integrated circuit devices 1300, or integrated circuit dies 1202 disclosed herein, and may be arranged in any of the transistor 100, 400 disclosed herein. A number of components are illustrated in FIG. 16 as included in the electrical device 1600, but any one or more of these components may be omitted or duplicated, as suitable for the application. In some embodiments, some or all of the components included in the electrical device 1600 may be attached to one or more motherboards mainboards, or system boards. In some embodiments, one or more of these components are fabricated onto a single system-on-a-chip (SoC) die.

Additionally, in various embodiments, the electrical device 1600 may not include one or more of the components illustrated in FIG. 16, but the electrical device 1600 may include interface circuitry for coupling to the one or more components. For example, the electrical device 1600 may not include a display device 1606, but may include display device interface circuitry (e.g., a connector and driver circuitry) to which a display device 1606 may be coupled. In another set of examples, the electrical device 1600 may not include an audio input device 1624 or an audio output device 1608, but may include audio input or output device interface circuitry (e.g., connectors and supporting circuitry) to which an audio input device 1624 or audio output device 1608 may be coupled.

The electrical device 1600 may include one or more processor units 1602 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1602 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1600 may include a memory 1604, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1604 may include memory that is located on the same integrated circuit die as the processor unit 1602. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1600 can comprise one or more processor units 1602 that are heterogeneous or asymmetric to another processor unit 1602 in the electrical device 1600. There can be a variety of differences between the processing units 1602 in a system in terms of a spectrum of metrics of merit including architectural, microarchitectural, thermal, power consumption characteristics, and the like. These differences can effectively manifest themselves as asymmetry and heterogeneity among the processor units 1602 in the electrical device 1600.

In some embodiments, the electrical device 1600 may include a communication component 1612 (e.g., one or more communication components). For example, the communication component 1612 can manage wireless communications for the transfer of data to and from the electrical device 1600. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1612 may operate in accordance with other wireless protocols in other embodiments. The electrical device 1600 may include an antenna 1622 to facilitate wireless communications and/or to receive other wireless communications (such as AM or FM radio transmissions).

In some embodiments, the communication component 1612 may manage wired communications, such as electrical, optical, or any other suitable communication protocols (e.g., IEEE 802.3 Ethernet standards). As noted above, the communication component 1612 may include multiple communication components. For instance, a first communication component 1612 may be dedicated to shorter-range wireless communications such as Wi-Fi or Bluetooth, and a second communication component 1612 may be dedicated to longer-range wireless communications such as global positioning system (GPS), EDGE, GPRS, CDMA, WiMAX, LTE, EV-DO, or others. In some embodiments, a first communication component 1612 may be dedicated to wireless communications, and a second communication component 1612 may be dedicated to wired communications.

The electrical device 1600 may include battery/power circuitry 1614. The battery/power circuitry 1614 may include one or more energy storage devices (e.g., batteries or capacitors) and/or circuitry for coupling components of the electrical device 1600 to an energy source separate from the electrical device 1600 (e.g., AC line power).

The electrical device 1600 may include a display device 1606 (or corresponding interface circuitry, as discussed above). The display device 1606 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1600 may include an audio output device 1608 (or corresponding interface circuitry, as discussed above). The audio output device 1608 may include any embedded or wired or wirelessly connected external device that generates an audible indicator, such as speakers, headsets, or earbuds.

The electrical device 1600 may include an audio input device 1624 (or corresponding interface circuitry, as discussed above). The audio input device 1624 may include any embedded or wired or wirelessly connected device that generates a signal representative of a sound, such as microphones, microphone arrays, or digital instruments (e.g., instruments having a musical instrument digital interface (MIDI) output). The electrical device 1600 may include a Global Navigation Satellite System (GNSS) device 1618 (or corresponding interface circuitry, as discussed above), such as a Global Positioning System (GPS) device. The GNSS device 1618 may be in communication with a satellite-based system and may determine a geolocation of the electrical device 1600 based on information received from one or more GNSS satellites, as known in the art.

The electrical device 1600 may include an other output device 1610 (or corresponding interface circuitry, as discussed above). Examples of the other output device 1610 may include an audio codec, a video codec, a printer, a wired or wireless transmitter for providing information to other devices, or an additional storage device.

The electrical device 1600 may include an other input device 1620 (or corresponding interface circuitry, as discussed above). Examples of the other input device 1620 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1600 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1600 may be any other electronic device that processes data. In some embodiments, the electrical device 1600 may comprise multiple discrete physical components. Given the range of devices that the electrical device 1600 can be manifested as in various embodiments, in some embodiments, the electrical device 1600 can be referred to as a computing device or a computing system.

### EXAMPLES

Illustrative examples of the technologies disclosed herein are provided below. An embodiment of the technologies may include any one or more, and any combination of, the examples described below.

Example 1 includes a device comprising a transistor comprising a substrate; a semiconductor layer; a ferroelectric layer between a gate and the semiconductor layer; and a barrier layer adjacent the substrate and between the substrate and the ferroelectric layer, wherein the barrier layer comprises titanium and nitrogen.

Example 2 includes the subject matter of Example 1, and wherein the barrier layer is adjacent the ferroelectric layer, wherein one or more electrodes are connected to the barrier layer, wherein the barrier layer is conductive, wherein the barrier layer comprises the gate.

Example 3 includes the subject matter of any of Examples 1 and 2, and wherein the gate is separate from the barrier layer.

Example 4 includes the subject matter of any of Examples 1-3, and wherein the barrier layer has a thickness of 10 to 50 nanometers.

Example 5 includes the subject matter of any of Examples 1-4, and wherein the ferroelectric layer has a thickness of 20 to 50 nanometers.

Example 6 includes the subject matter of any of Examples 1-5, and wherein the ferroelectric layer comprises a perovskite.

Example 7 includes the subject matter of any of Examples 1-6, and wherein the semiconductor layer is a perovskite.

Example 8 includes the subject matter of any of Examples 1-7, and wherein the semiconductor layer comprises barium, tin, and oxygen.

Example 9 includes the subject matter of any of Examples 1-8, and wherein at least part of the semiconductor layer is doped with lanthanum.

Example 10 includes the subject matter of any of Examples 1-9, and wherein the barrier layer is domain matched to the substrate with a mismatch of less than 1%.

Example 11 includes the subject matter of any of Examples 1-10, and wherein the barrier layer has a face-centered cubic crystal structure, wherein the substrate has a face-centered cubic crystal structure.

Example 12 includes the subject matter of any of Examples 1-11, and wherein the ferroelectric layer comprises barium, titanium, and oxygen.

Example 13 includes the subject matter of any of Examples 1-12, and wherein the substrate comprises silicon.

Example 14 includes the subject matter of any of Examples 1-13, and wherein the transistor is a FinFET, a gate-all-around transistor, or a stacked gate-all-around-transistor.

Example 15 includes a processor comprising the device of any of Eexamples 1-14.

Example 16 includes a system comprising the processor of Example 15 and one or more memory devices.

Example 17 includes a device comprising a substrate; a source; a drain; a channel between the source and the drain; a ferroelectric layer between a gate and the channel; and a barrier layer adjacent the substrate and between the substrate and the ferroelectric layer, wherein the barrier layer comprises titanium and nitrogen.

Example 18 includes the subject matter of Example 17, and wherein the barrier layer is adjacent the ferroelectric layer, wherein one or more electrodes are connected to the barrier layer, wherein the barrier layer is conductive.

Example 19 includes the subject matter of any of Examples 17 and 18, and wherein the gate is separate from the barrier layer.

Example 20 includes the subject matter of any of Examples 17-19, and wherein the barrier layer has a thickness of 10 to 50 nanometers.

Example 21 includes the subject matter of any of Examples 17-20, and wherein the ferroelectric layer has a thickness of 20 to 50 nanometers.

Example 22 includes the subject matter of any of Examples 17-21, and wherein the ferroelectric layer comprises a perovskite.

Example 23 includes the subject matter of any of Examples 17-22, and wherein the channel is a perovskite.

Example 24 includes the subject matter of any of Examples 17-23, and wherein the channel comprises barium, tin, and oxygen.

Example 25 includes the subject matter of any of Examples 17-24, and wherein at least part of the channel is doped with lanthanum.

Example 26 includes the subject matter of any of Examples 17-25, and wherein the barrier layer is domain matched to the substrate with a mismatch of less than 1%.

Example 27 includes the subject matter of any of Examples 17-26, and wherein the barrier layer has a face-centered cubic crystal structure, wherein the substrate has a face-centered cubic crystal structure.

Example 28 includes the subject matter of any of Examples 17-27, and wherein the ferroelectric layer comprises barium, titanium, and oxygen.

Example 29 includes the subject matter of any of Examples 17-28, and wherein the substrate comprises silicon.

Example 30 includes the subject matter of any of Examples 17-29, and wherein the device is a FinFET, a gate-all-around transistor, or a stacked gate-all-around-transistor.

Example 31 includes a processor comprising the device of any of Examples 17-30.

Example 32 includes a system comprising the processor of Example 31 and one or more memory devices.

Example 33 includes a method comprising depositing a barrier layer on a substrate using domain matching epitaxy, wherein the barrier layer comprises titanium and barium; depositing a ferroelectric layer located on the barrier layer; and depositing a semiconductor layer located on the barrier layer.

Example 34 includes the subject matter of Example 33, and wherein the ferroelectric layer is adjacent the barrier layer, wherein the semiconductor layer is adjacent the ferroelectric layer.

Example 35 includes the subject matter of any of Examples 33 and 34, and wherein substrate comprises silicon, wherein the barrier layer prevents formation of SiO on the substrate during deposition of other layers.

Example 36 includes the subject matter of any of Examples 33-35, and wherein the barrier layer is adjacent the ferroelectric layer, wherein one or more electrodes are connected to the barrier layer, wherein the barrier layer is conductive.

Example 37 includes the subject matter of any of Examples 33-36, and further including depositing a gate layer on the barrier layer.

Example 38 includes the subject matter of any of Examples 33-37, and wherein the barrier layer has a thickness of 10 to 50 nanometers.

Example 39 includes the subject matter of any of Examples 33-38, and wherein the ferroelectric layer has a thickness of 20-50 nanometers.

Example 40 includes the subject matter of any of Examples 33-39, and wherein the ferroelectric layer comprises a perovskite.

Example 41 includes the subject matter of any of Examples 33-40, and wherein the semiconductor layer is a perovskite.

Example 42 includes the subject matter of any of Examples 33-41, and wherein the semiconductor layer comprises barium, tin, and oxygen.

Example 43 includes the subject matter of any of Examples 33-42, and wherein at least part of the semiconductor layer is doped with lanthanum.

Example 44 includes the subject matter of any of Examples 33-43, and wherein the barrier layer is domain matched to the substrate with a mismatch of less than 1%.

Example 45 includes the subject matter of any of Examples 33-44, and wherein the barrier layer has a face-centered cubic crystal structure, wherein the substrate has a face-centered cubic crystal structure.

Example 46 includes the subject matter of any of Examples 33-45, and wherein the ferroelectric layer comprises barium, titanium, and oxygen.

Example 47 includes the subject matter of any of Examples 33-46, and wherein the substrate comprises silicon.

## Claims

1. A device comprising:
a transistor comprising:
a substrate;
a semiconductor layer;
a ferroelectric layer between a gate and the semiconductor layer; and
a barrier layer adjacent the substrate and between the substrate and the ferroelectric layer, wherein the barrier layer comprises titanium and nitrogen.

2. The device of claim 1, wherein the barrier layer is adjacent the ferroelectric layer, wherein one or more electrodes are connected to the barrier layer, wherein the barrier layer is conductive, wherein the barrier layer comprises the gate.

3. The device of claim 1, wherein the gate is separate from the barrier layer.

4. The device of any one of claims 1-3, wherein the barrier layer has a thickness of 10 to 50 nanometers.

5. The device of any one of claims 1-4, wherein the semiconductor layer comprises barium, tin, and oxygen.

6. The device of claim 5, wherein at least part of the semiconductor layer is doped with lanthanum.

7. The device of any one of claims 1-6, wherein the barrier layer is domain matched to the substrate with a mismatch of less than 1%.

8. The device of any one of claims 1-7, wherein the barrier layer has a face-centered cubic crystal structure, wherein the substrate has a face-centered cubic crystal structure.

9. The device of any one of claims 1-8, wherein the ferroelectric layer comprises barium, titanium, and oxygen.

10. The device of any one of claims 1-9, wherein the transistor is a FinFET, a gate-all-around transistor, or a stacked gate-all-around-transistor.

11. A processor comprising the device of any one of claims 1-10.

12. A method comprising:
depositing a barrier layer on a substrate using domain matching epitaxy, wherein the barrier layer comprises titanium and barium;
depositing a ferroelectric layer located on the barrier layer; and
depositing a semiconductor layer located on the barrier layer.

13. The method of claim 12, wherein the ferroelectric layer is adjacent the barrier layer, wherein the semiconductor layer is adjacent the ferroelectric layer.

14. The method of any one of claims 12-13, wherein substrate comprises silicon, wherein the barrier layer prevents formation of silicon monoxide on the substrate during deposition of other layers.

15. The method of any one of claims 12-14, wherein the barrier layer is adjacent the ferroelectric layer, wherein one or more electrodes are connected to the barrier layer, wherein the barrier layer is conductive.
